(19) Europäisches Patentamt
European Patent Office
Office européen des brevets

(11) **EP 2 073 024 A1**

(12) **EUROPEAN PATENT APPLICATION**
published in accordance with Art. 153(4) EPC

(43) Date of publication:
**24.06.2009 Bulletin 2009/26**

(51) Int Cl.:
***G01R 15/12*** *(2006.01)*

(21) Application number: **06840654.5**

(22) Date of filing: **26.12.2006**

(86) International application number:
**PCT/CN2006/003611**

(87) International publication number:
**WO 2008/034306 (27.03.2008 Gazette 2008/13)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **18.09.2006 CN 200610062667**

(71) Applicants:
• **Zang, Jiajing**
  **Shenzhen 518112 (CN)**
• **Zang, Yulun**
  **Shenzhen 518112 (CN)**

(72) Inventors:
• **Zang, Jiajing**
  **Shenzhen 518112 (CN)**
• **Zang, Yulun**
  **Shenzhen 518112 (CN)**

(74) Representative: **Hryszkiewicz, Danuta**
**Kancelaria Patentowa**
**ul. Jana z Kolna 38**
**PL-75-204 Koszalin (PL)**

(54) **A DIGITAL MULTIMETER WITH AUTOMATIC MEASUREMENT SELECTION FUNCTION**

(57)    A digital mutimeter with automatic selection function includes measured object input ports (1,2,3), a high speed A/D source (A), a microprocessor (B), an assistant programme control voltage or current source (D), a voltage divider network, electronic switches, and a display (C). The high speed A/D converter (A) is connected to measured object input ports (1, 2, 3) via the voltage divider network and measures the voltage between the input ports quickly. Then, the high speed A/D converter (A) transmits data to the microprocessor (B), and the microprocessor (B) control electronic switches to switch the voltage divider network to select the measurement range of the high speed A/D converter (A). The microprocessor (B) can control the assistant programme control voltage or current source (D) to be connected to a passive measure object on the input ports, and select the measurement mode and range of the passive measured object. The microprocessor (B) control the display (C) to show the measurement result.

Fig. 1

## EP 2 073 024 A1

**Description**

The invention relates to a digital multimeter, and particularly to a digital multimeter that realizes automatic selection of multiple categories of analog amount measurement functions and measuring ranges based on measured object with a voltmeter consisting of a high speed A/D as the core, together with proper auxiliary power supply and microprocessor as well as electronic switches.

The common digital multimeter generally provide mechanical or button type function selection switch for users to judge and select measurements by themselves. For example, as to whether the measured object is DC/AC voltage, resistance, or DC/AC current, the knob switch is turned to corresponding function measurement position and some electrical connections are generated by metal contact to form certain measurement circuit for DC/AC voltage, resistance or current. The digital multimeter with automatic measuring range, after selecting a measurement function, can select a proper measuring range by different combination of internal electronic positions in accordance with the size of the measured object. Therefore, it can complete measurement of measured values of different sizes (e.g. DC voltage) with only one position after a measurement function is selected (e.g. DC voltage); for multimeter with manual measuring range, the measurement of a certain measurement function within the whole measurement scope can be done by corresponding several positions to measured values (e.g. DC voltage) of different sizes. They all cannot select measurement functions automatically.

There have been designed that add selection of measurement function based on digital multimeter with automatic measuring ranges. However, a signal type detector is generally required to detect the type of analog input signal; the types of analog input signal that can be judged are limited. Moreover, the influences by the input impedance and switches of the signal type detector reduces the performance of the multimeter with automatic selection of measurement functions it formed, even making them having little practical value.

A considerable improvement has been made for multimeter with automatic selection of measurement functions in China patent number 200310112175.3, bringing the multimeter with automatic selection of measurement functions into a practical era. However, in terms of automatic selection of non-voltage/current passive analog input, there is still great limit, such as for measurement of capacitor, inductance and diode.

An objective of the invention is to provide a new-type digital multimeter with automatic measuring range, which not only can automatically select the measurement functions based on whether is measured object is DC/AC voltage, resistance or DC current, but has the feature of automatically selecting measurement functions against more types of passive components including resistance, such as measurement of resistance, capacitor, inductance and diode. Under the simplest conditions, the ON/OFF of this multimeter can be done only by ON/OFF of a power supply. Moreover, it has a faster response speed than a common multimeter with automatic measuring range during measurement.

The objective of the invention is implemented as follows: the digital multimeter that automatically select measurement functions in this invention include measured object input port, conversion circuit of high speed A/D, microprocessor, assistant programme control voltage or current source, voltage divider network as well as electronic switch and display. The high speed A/D connects with the measured object input port through the voltage divider network for fast measurement of voltage between input ports; the high speed A/D outputs data to the microprocessor for analysis and processing, and the microprocessor controls the electronic switch in switching the voltage divider network and the range of the measurement; and the measurement result is sent to the display for displaying after being processed by the microprocessor.

In the invention, when the multimeter detects external voltage at the said input port, the microprocessor, based on whether there is cyclic change of polarity for the data output by the high speed A/D, can automatically judge it as DC or AC signal, and works out the polarity and value of a DC signal as well as numerical results including peak value, effective value, frequency and cycle by analysis and processing. Of course, only when the sampling speed of the high speed A/D must be several folds higher than the frequency of the measured AC signal, the measured AC signal can be precisely measured.

In the invention, when the multimeter does not detect any external voltage, it will enter the measurement procedure of passive analog measured object. The microprocessor controls the assistant programme control voltage/ current source to output to the input port and the high speed A/D circuit inputs the measured result into the microprocessor for analysis to judge the nature of the measured passive analog amount object. When the assistant programme control voltage/current is active analog amount measured object at the input port, the connection to the input port will be cut off; when the assistant programme control voltage/current is passive analog amount measured object at the input port, the connection to the input port will be connected. The high speed A/D circuit and program-controlled voltage/current source controlled by the microprocessor combine to select multiple types of analog amount measurements as well as measuring range. As to the measurement of the analog amount object, the auxiliary program-controlled source first outputs a micro test current to keep the input port as a circuit with high input impedance.

In the invention, the microprocessor receives output of measurement data and controls the electronic switch of the program-controlled voltage/current sources based on data output control signal to change the nature and size of the program-controlled source and thus the measuring range. The microprocessor, by storing partial measurement data, can store and display the waveform graphic of variation of input signal along with the time as well as graphic of value variation along with the time.

In the invention, a selection button connecting with the microprocessor is provided, by which automatic selection of measurement can exit to switch to the measurement function that switches at every push of the button.

Comparing with the existing technology, this invention, with the adoption of fast analog/digital conversion technology and the method that a certain auxiliary power source is applied when measuring the passive analog amount, can measure the different responses between the input ports after the auxiliary power source is applied during measurement of passive amount when forming the multimeter that automatically selects measurement functions, thus being able to automatically judge the nature and size of the measured object and making it possible for automatic selection of measurement functions for more analog amount that previously could not be automatically identified as well as automatic selection of measuring ranges..

Comparing with the existing technology, this invention, when measuring AC signal, can not only work out the true effective value of the AC signal, but obtain data of the AC signal including frequency and peak voltage, while common multimeter can achieve true effective value measurement only by converting AC into DC by adding special true effective value converter. Moreover, this invention, comparing with common true effective value multimeter, also can make no error in range judgment when measuring AC signal with non-sine large crest factor (high peak voltage but small effective value), while common true effective value multimeters possibly make error in range judgment at that time, generating great error.

In the invention, comparing with existing technology, can always obtain more precise data in terms of measurement of DC signal from AC half wave rectification or full wave rectification, or measurement of unidirectional pulse signal.

Comparing with the existing technology, this invention, with improvement of measurement speed by adopting fast analog/digital conversion technology, not only can measure the transitional responses of energy storage elements including capacitor and inductance, but shortens the time of probing measurement of functions. The time for measuring range selection and switching is also shortened, and the response of the entire multimeter greatly increased, with problems of long standby time against common multimeter with automatic measuring range being solved.

Meanwhile, this invention also allows the continuity warning function that gives warning sound when a resistance value less than a certain value is measured to be realized in the multimeter that automatically selects measurement functions. For other multimeters, this function and diode measurement function can be realized by setting separate measurement function position, to solve the requirements that continuity measurement expects a fast response by features that the analog comparison method is fast. Since common multimeter with automatic measuring range undergoes several range conversion from the open circuit of meter to measurement of a resistance below a certain value (e.g. 30ohm), causing a slow response.

Fig. 1 is a a block diagram of main features in implementation of multimeter formed based on this invention;

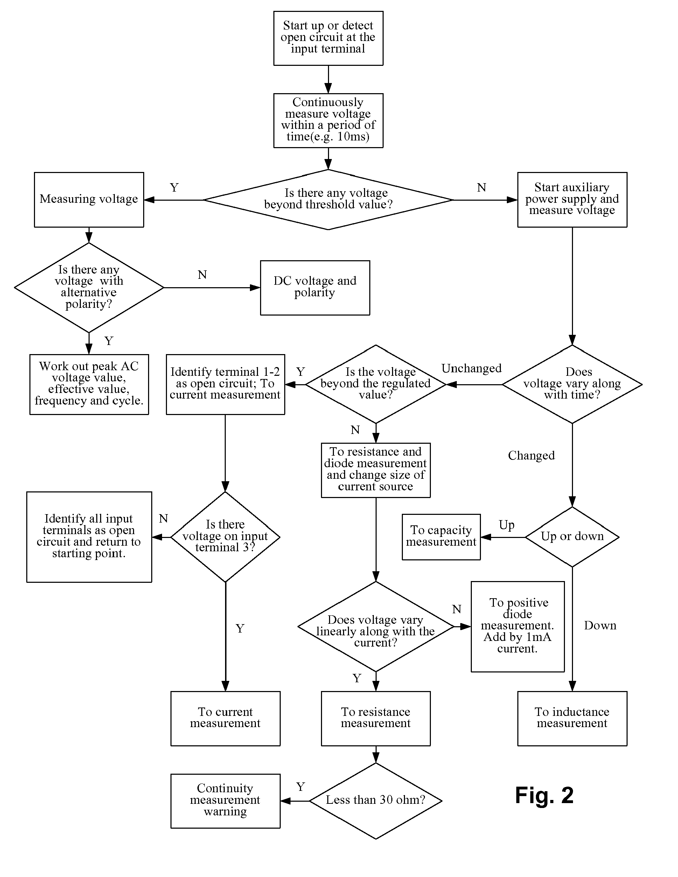

Fig. 2 is a flow chart of main function procedure or state for the automatic selection of measurement function in the implementation shown in Fig. 1;

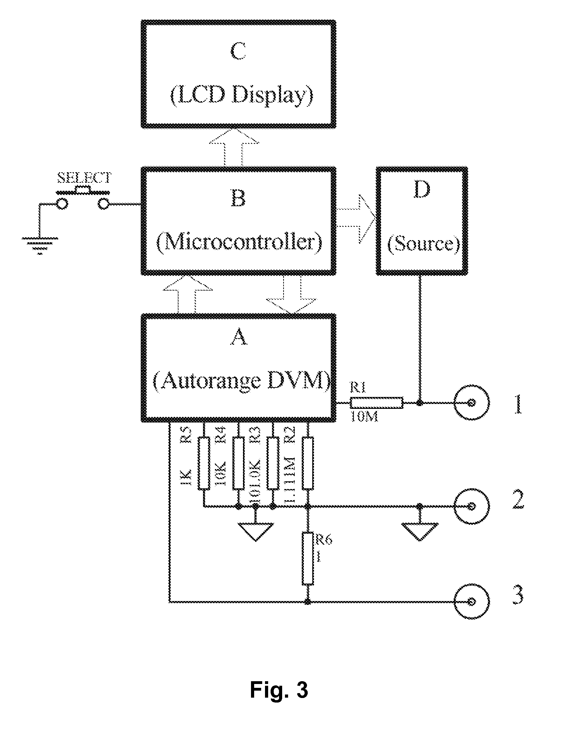

Fig. 3 is a principle diagram of the digital multimeter that realizes selection of measurement functions only by one button by adding a function selection button; and

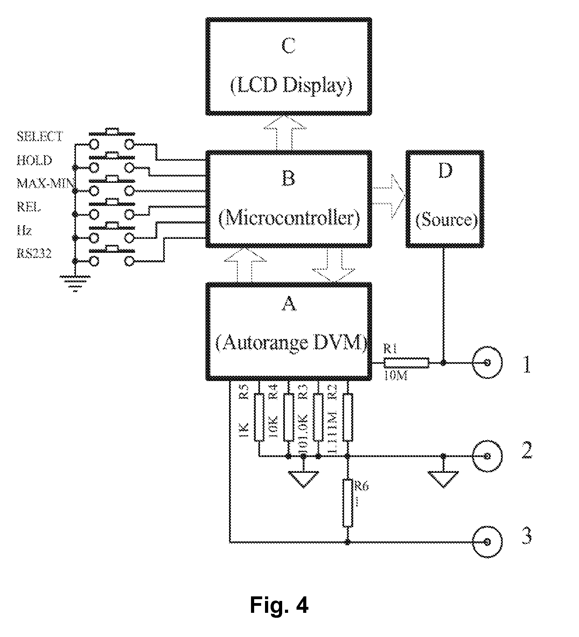

Fig. 4 is principle drawing of the digital multimeter after the auxiliary function selection button is added.

The accompanying drawings disclose an embodiment of the invention, which should not be interpreted as particular limitation to the structure of the invention, and further description will be given below in conjunction with the accompanying drawings.

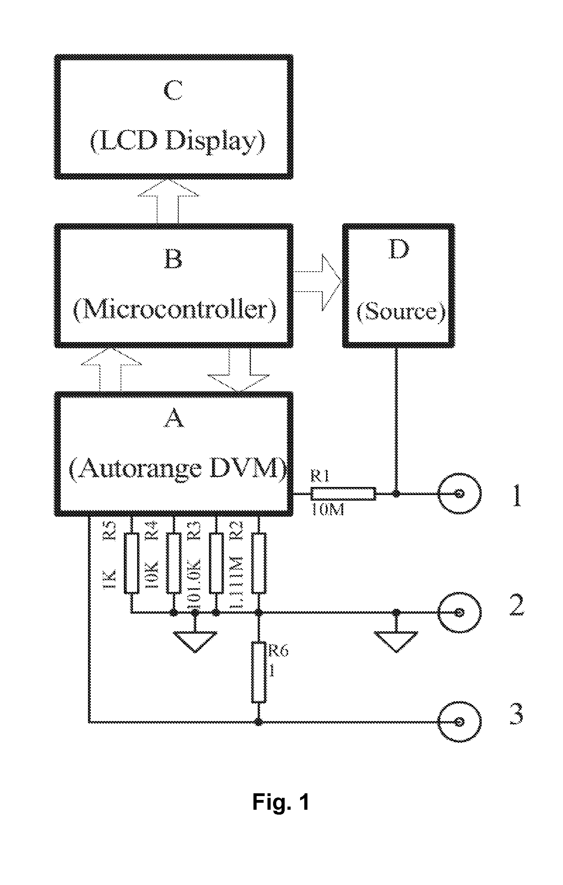

Below is the further detailed description of this invention by combining the attached diagram. See Fig. 1. This figure includes three input ports: 1, 2 and 3 as well as four circuit parts: A, B, C and D. Among them, Part A is High speed A/D; Part B is Microprocessor; Part C is Display, and Part D is a Voltage/Current Source controlled by Part B. Input port 2 is a common input port, which, just like a common multimeter, represents the measured signal ground. Input port 1 is the input port of all measured analog amount except of current measurement. During measurement, these measured analog amount object are connected between Terminal 1 and2. Input port 3 is the input port of current measurement and the measured current signal is connected between Input port 3 and 2. There is already Resistance R6 connected between Input port 3 and 2, whose function is to convert the current signal into voltage signal. During current measurement, the voltmeter with automatic measuring range formed by high speed A/D measures the voltage between Terminal 3 and 2, which represents the nature and size of the measured current. The selection of size and power of R6 resistance depends on the size of measurement current. When current measurement is not necessary, this input port and R6 can be ignored.

In Fig. 1, Part A is a voltmeter with automatic range that takes the high speed A/D as the core and consists of electronic switch controlled by Part B as well as Resistance R1, R2, R3, R4 and R5. In accordance with the size of input voltage, the ON/OFF of the electronic switch controlled by Part B allows R1 -R5 to be combined into voltage divider network with a voltage ratio of 1,10,100,1000 and 10000, enabling input voltage of different size to be converted into the measurement scope of the high speed A/D. For example, the corresponding voltage range is 400mV, 4V, 40V, 400V and 1000V. Under voltage ratio 1 that is to directly input 400mV basic range without attenuation, Part A has very high input impedance and has an impedance of 10M ohm under other conditions. Just with a conversion speed of the high speed A/D that is fast enough, the data and variation between the input ports can be obtained within a certain scope. The high speed A/D here refers to the one that can convert for more than several thousand times per second, rather than the low-speed analog/digital converter used in common multimeter that can convert several times per second. Moreover, the adoption of high speed A/D allows the time spent for the multimeter to judge measurement functions and convert to a proper range to be even shorter, unlike the existing common multimeter with automatic range that will wait for a long time to obtain a stable measurement result.

Part B is a microprocessor, which both receives measurement data output from Part A and outputs control signal to control the electronic switch of Part A and change the range based on the conditions of the data, making Part A a voltmeter with automatic range. In fact, a waveform graphic of input signal variation along with the time can be stored by storing partial measurement data output of Part A. For this reason, in accordance with the variation of voltage signal and cyclic change of direction (polarity), it can identify if the voltage signal is AC or DC, or both, and make corresponding treatment. It can make the display showing not only the numeric value result of the measurement, but the waveform graphic of the measured object or its value variation along with the time upon demands. IF there is voltage exceeding the preset threshold value between Input port 1 and 2, the multimeter will enter and keep the voltage measurement and automatically position on a proper range. The purpose of setting a threshold value is to avoid error function judgment caused by external interference signal in the event of open circuit of input port.

After Part A does not detect any voltage signal exceeding the threshold value for a period of time (e.g. 10ms), Part B will enter the test procedures for passive analog amount. Part B controls Part D to generate a controlled current input to Input port 1, while output of Part D is not connected with Input port 1 prior to that. The non-voltage measurement object can be judged as resistance, diode, capacitor or inductance or that the input port is under open circuit in accordance with the measurement result of voltage variation between Input port 1 and 2 by Part A at that time.

If Input port 1 and 2 is detected as open circuit, Part B controls Part A to switch to measure the voltage between input port 3 and 2. When a voltage exceeding a certain threshold value is detected, it will be under current measurement state. The identification of AC or DC current is as the same as that for the above voltage.

If no current input is detected between Input port 3 and 2, Part B will return the measurement to the original state, enabling Part A to begin detecting voltage between Input port 1 and 2. Repeat according to the above steps.

Part C is a display, which can display the corresponding measurement results and unit symbol in accordance with the data Part B outputs. If required, its waveform graphic or variation graphic of various measured objects along with time through the measured numeric results can also be displayed when measuring AC voltage or current, which can be done just when Part B stores and outputs proper data signal.

Part D is the voltage or current source controlled by Part B. Controlled by Part B; it can output voltage or current signal of different size and waveform to Input port 1, meeting the demands of measurement for different measured objects. For example 0.01μA, 1μA or 1 mA DC current or triangle wave current of different slope can be output. Its maximum output voltage is controlled as, for example 2V. Under voltage measurement state, its connection with Input port 1 is opened.

The principle of judgment and measurement of resistance, capacitor, inductance and diode is based on their different response against different voltage or current source.

When the measured object is resistance or diode, or energy storage element capacitor or inductance, the voltage/current relation is respectively:

1) Relationship between voltage $u_R$ and current $i_{R_c}$ flowing the resistance is :

$$u_R = i_{R_c} R, \quad \text{or } R = \frac{u_R}{i_R} \qquad (1)$$

2) Relationship between current $i_c$ flowing Capacitor C and voltage $u_c$ on capacitor along with time change rate $\frac{du_c}{dt}$ is:

$$i_c = c\frac{du_c}{dt} \quad , \quad \text{or } i_c = c\frac{\Delta u_c}{\Delta t} \qquad (2)$$

3) Relationship between current $i_L$ flowing inductance L and voltage $u_L$ on inductance along with the time change rate $\dfrac{di_L}{dt}$ is:

$$u_L = L\frac{di_L}{dt} \quad , \quad \text{or } u_L = L\frac{\Delta i_L}{\Delta t} \qquad (3)$$

4) For voltage/current relationship of diode, the following expression of diode's PN junction V-A characteristics analyzed in theory based principle of semiconductor physics, which is commonly called diode equation:

$$I = I_S(e^{U/U_T} - 1) \qquad (4)$$

In the equation, $I_S$ is reverse saturation current, $U_T$ temperature's current equivalent. Under normal temperature (300˚K), $U_T \approx 2.6mV$.

From the above diode equation, we can see that, if the diode is applied a backward voltage U<0, and $|U| \gg U_T$, $I \approx -I_S$. That is, the backward voltage is basically a constant value. If the diode is applied a forward voltage, U>0 and $U \gg U_T$, then $e^{U/U_T} \gg I$ in the above equation, and thus $I \approx I_S e^{U/U_T}$, showing that forward current I and voltage U is basically of exponential relationship.

Generally, when measuring a diode by multimeter, it is to measure the diode in both forward and backward direction that judges its quality. It shows OL in back direction because the diode shows high impedance and shows forward voltage drop of the diode in forward direction, generally the forward voltage drop at a 1 mA current.

For this reason, when measuring a resistance, Part A will not measure any voltage when passing through passive components including discharged capacitor, inductance or diode. At that time, Part D injects a constant current or voltage source connecting a resistance of certain value in series to Input port 1. The measured object connected between Input port 1 and 2, as a resistor, capacitor, inductance or diode, will show different response, resulting in different variation of voltage between Input port 1 and 2.

As to a measured object that is resistance; based on Formula (1), the voltage measured by Part A is in direct proportion with the resistance value, also the current through the resistance. For this reason, when Part D controlled by the microprocessor generates and applies a known constant current, the voltage measured by Part A is a fixed value; as the value of the constant value is changed, the voltage on the resistance will change in proportion. By calculating the ratio between the voltage measured by Part A and the known constant current, we can get the numeric result of the resistance value. The state exceeding the maximum resistance measurement scope regulated by the multimeter is viewed an open circuit. The proportion method commonly seen in common multimeters can also be taken in measuring the resistance.

As to measurement of a diode, it shows that it is similar with that of resistance, but difference from that of capacitor or inductance. Since Capacitor and inductor pertain to energy storage element, they will show time-related responses when being applied a constant current at its both ends suddenly. For backward measurement of diode, the constant current applied at its both ends generally shows a state of higher impendence or open circuit, even the highest output voltage (e.g. 2V) of Part D by making Part D unable to output expected current value. For forward measurement, based on Formula (4), when Part D controlled by the microprocessor generates and applies a known constant current, the voltage measured by Part A is a fixed value, representing a fixed impendence. By changing the value of the constant current, the voltage measured by Part A will not change in proportion as that of a resistance. The more the current is, the less the impedance shows. For this reason, diode measurement can be separated from the resistance measurement state. When the constant current is changed by 1 mA, we can get the numeric value of the forward voltage drop of the diode at 1 mA current.

As to capacitor measurement, based on Formula (2), when a constant current is suddenly applied at both ends of the discharged capacitor to be measured, there will be voltage at its both ends that vary starting from zero as the time increases. The change rate $\dfrac{\Delta u_c}{\Delta t}$ of this voltage is in direct proportion with the value of the current applied and in inverse proportion with the capacity of the measured capacitor. Knowing the value $i_c$ of current output from Part D and measuring with Part A the variation value $\Delta u_c$ of voltage on the capacitor in a certain time interval $\Delta t$, we can get the numeric value of the capacity of the measured capacitor: $C = \dfrac{i_c \Delta t}{\Delta u_c}$. This equation is another expression of Formula (2). If the applied constant current is backward, the voltage on the capacitor will decrease, and the change rate of the voltage decrease is still in direct proportion with the value of the applied current and in inverse proportion with the capacity of the measured capacitor.

As to inductance, it is obvious from Formula (3) that the current of the measured inductance will not change suddenly. For this reason, when attempting to apply an expected current on the inductance, since the opposing electromotive force generated by the inductance will make Part D unable to output expected current value, thus resulting in maximum output voltage (e.g. 2V) for Part D. Under the action of this voltage, the current in the inductance will increase gradually till the current value expected by Part D is reached, the voltage at both ends of the inductance will decrease and finally this voltage will be maintained at the voltage drop generated on the inductance's essential resistance on the applied current. If the current suddenly interrupts, a large opposing electromotive force will be generated under the action of inductance, with a backward voltage generated at its both ends. Part B, sensing this feature, can switch to make Part D output a triangle wave. When the slope $\dfrac{di}{dt}$ of the triangle wave is fixed at a certain value, from Formula (3), there will be a constant voltage $u_L = L \dfrac{di}{dt}$ in direct proportion with the inductance, which is a positive value when current increases and negative value when decreases. In accordance with the slope $\dfrac{di}{dt}$ of current change and the voltage value measured $u_L$, we can get the numeric value of the inductance. Based on the voltage drop generated on the inductance's internal resistance measured by applying DC current at the time of starting judgment, we can get its internal resistance.

The flow chart in the reference diagram 2 below further describes the working process of this invention. At the starting point, after multimeter receives the information that the input port is under open circuit, the microprocessor will start function detection procedure. First, enable the high speed A/D of function part A to continuously measure voltage between input port 1 and 2 in a period of time (e.g. 10ms), to see if there is any voltage exceeding the regulated threshold value. As mentioned above, the purpose of setting a threshold is to avoid error function judgment caused external interference signal when the input port is under open circuit. The purpose of continuous observation for a period of time is to avoid that the high speed A/D makes an error judgment that there is no voltage input by just sampling the over zero point of the AC voltage when there is AC voltage (e.g. 50Hz) input.

If there is a voltage exceeding the threshold value that is applied between Input port 1 and 2, after judgment by the microprocessor, the multimeter will enter the procedure of voltage measurement. Generally, when starting measuring, Part A, the fast voltmeter with automatic range will be under the maximum range of voltage measurement and then is adjusted to a proper range in accordance with the peak voltage measured. Based on the data measured, it is easy to know whether there is any voltage with alternative polarity.

If there is voltage with alternative polarity, the measured voltage is AC voltage. As long as the high speed A/D can get enough quantity of sample value within a cycle of AC voltage, it is easy to get the data of this AC voltage including peak value, true effective value, frequency or cycle. These measurement results can be selected to be fully or partially displayed upon demands. Obviously, the sampling speed of the high speed A/D and the processing speed of the microprocessor limit the maximum frequency width of the measurable AC voltage. This invention, by adopting another advantage brought by the high speed A/D, will not make significant measurement errors caused by error selection of range when measuring alternation waveform signal with high peak factor (high peak voltage but low effective value), which will be seen for common true effective value multimeter with automatic range. Since the multimeter in this invention selects a range based on the peak voltage measured, what is measured is a true and complete waveform, while common true effective value multimeter, selecting range based on effective value of voltage, will make significant topping of peak voltage and thus generate significant error.

If there is no voltage with alternative polarity, the measured voltage is DC voltage, and its polarity is known at the same time. The whole measurement is done just by sending the voltage value and its polarity to Part C display for displaying by Part B. For DC signal overlapping with AC ripples, there will be fluctuation against the data measured by the fast voltmeter with automatic range. The common treatment is, just like treatment against AC signal, to work out the true effective value within a period of time as the result of the final measurement. For measurement of DC signal from AC half-wave rectification or full wave rectification or measurement of unidirectional pulse signal, precise data all can be obtained. Upon different demands, we can additionally work out and display the peak value or effective value.

For the case that no voltage exceeding the regulated threshold value is detected, the multimeter is under the state of measurement function for passive components. Part B's microprocessor will control the auxiliary power supply of Part D in injecting different test current including 0.01µA, 1µA and 1 mA to input port 1 in sequence. Its maximum output voltage is, for example, 2V.

When the current source is 0.01µA, 1µA, function part A will be under the state of direct input of high input impedance without attenuation, with its range scope as, for example, ±400.0mV. When the current source is 1 mA, Part A will be under the state of input with 10-fold attenuation, with its range scope as ±4.000 V.

Each time after different current is injected, Part A will continuously measure the voltage between input port 1 and 2 and Part B identifies whether there is variation along with time. Since there will never be voltage that varies along with the time under the action of certain current no matter for resistance measurement, diode measurement or input port under open circuit, such a case will occur only when energy storage elements such as capacitor or inductance is connected between the input port. For this reason, after a fixed current source is suddenly applied to Input port 1 and 2, a judgment can be made in accordance whether the voltage occurred varies along with time to distinguish the measurement of inductance from capacitor. This step of judgment can be ignored if the automatic detection and measurement of such energy storage elements as capacitor and inductance is not necessary.

If an inductance is connected between input ports, since the current in the inductance will not change suddenly, there will first be a high voltage (equal to the voltage value of the current source's maximum output voltage) and after a period of transition the voltage finally reaches the value of voltage drop of the currently applied by current source on this inductance's internal resistance because the current in the inductance increases to the output value expected by the current source. This is commonly a small voltage value, which is below +400mV. Based on this feature, we can judge whether an inductance measurement is necessary. After entering inductance measurement procedures, the current source switches to output a triangle wave of a certain slope and there will be voltage related to inductance and drive current slope between Input port 1 and 2. Changing the slope based on the voltage measured, automatic selection of different proper range for inductance of different size can be realized.

If a discharged capacitor is connected between input ports, since the voltage on the capacitor will not change suddenly, there will be voltage increase linearly from zero along with time. Base on this feature of transitional procedure, we can judge whether capacitor measurement is necessary. After entering capacitor measurement procedures, the charging speed can be changed by changing the current output from the current source and automatic range selection is available by selecting a proper current value based on the size of the measured capacitor. For continuous measurement for the measured capacitor, when the voltage on the capacitor is charged to a certain value (e.g. 400mV), the current source will switch to generate an action that enables the capacitor to discharge, say, enabling the measured capacitor to be short circuit or applying a backward current. However, the capacitor has to be discharged prior to measurement, otherwise the multimeter will enter voltage measurement state to measure this voltage rather than capacitor, if there is residual voltage exceeding the threshold voltage on the capacitor.

If no voltage variation along with time is detected or automatic identification and measurement of inductance and capacitor functions is not necessary, the multimeter will enter measurement procedure for resistance or diode. At that time, there will be following cases for current of different auxiliary power supply:

## Table 1 Response under Different Measurement Current

| Measurement Result / Measurement Current | | 0.01µA | 1µA | 1mA |
|---|---|---|---|---|
| Measured Object | | | | |
| Open Circuit (or R⟩ 40MΩ) | | ⟩ 400.0mV | ⟩ 400.0mV | 2V |
| Resistance | 400kΩ<R<40MΩ | < 400.0mV | ⟩ 400.0mV | 2V |
| | 400Ω≤R≤400kΩ | ≤ 004.0mV | ≤400.0mV | ≥400.0mV |

| R | R<400Ω（Note 1） | 000.0mV | < 000.4mV | < 400.0mV |
|---|---|---|---|---|
| Diode | Backward (Note 2) | High Impedance | High Impedance | 2V |
| | Forward (Note 3) | Higher Impedance | Lower Impedance | Lowest Impedance |

Note 1: If the commonly seen continuity measurement warning function for the multimeter is necessary, a judgment step can be added, which is to judge whether to give a buzz in accordance warning threshold value (e.g. less than 30 ohm) and the measurement result.

Note 2: Under backward state of diode, the said high impedance can be equal to open circuit, or impedance less than 40MΩ that can be measured by less current source for the difference of backward leakage current of each diode.

The following treatment is necessary at this time:

a. If the highest output voltage (e.g. 2V) of the current source is measured when the current source is 1 mA, the lower impedance measured shall be taken as the measurement result;

b. If the voltage measured is lower than the highest output voltage when the current source is 1 mA, the voltage measured at this time shall be taken as the measurement result, because it may be a Zener diode with a breakdown voltage lower than 2V, for example, a 1.2V Zener diode.

Note 3: Under forward state of diode, the said higher, lower and lowest impedance is in relative term. In accordance with the forward feature of diode, there is lower impedance when the through current is higher. At this time, the voltage value measured under 1 mA current shall be displayed in the way that common multimeter measures the diode.

We can judge whether it is an open circuit, or under resistance or diode measurement based on Table 1.

1. If all voltage measured exceeds the maximum range (400 mV) of the function component A at that time in the case of measurement current as 0.01µA and 1µA, while the voltage measured is close to the maximum output (2V) of the current source in the case of measurement current as 1 mA (at this time, the maximum range of the function part A is 4V), it is viewed that it is under open circuit state between Input port 1 and 2. Next, the function part A will detect that there is no voltage between Input port 3 and 2.

a. If there is voltage, switch to the current measurement state. Treat the measurement result, judge and display whether it is AC or DC current as well as its value in accordance with Ohm's Law and the size of current sense resistance connected to Input port 3 and 2.

b. If the voltage between Input port 3 and 2 is zero, it is viewed that all input ports are open circuit, enabling the whole measurement procedure back to the starting point.

2. The following three cases all fall into the category of resistance measurement:

a. When the voltage measured is less than 400mV at $0.01\mu$A current source current, higher than the maximum measurement value (400mV) at this time at $1\mu$A, and the maximum output of the current source measured is 2V (at this time, the measuring range of the voltmeter has been changed to max. 4V) at 1 mA current source current, the $0.01\mu$A is selected as the measurement current. The value of the measured resistance can be worked out in accordance with Formula (1), which is between 400 K$\Omega$ and 40M$\Omega$.

b. When the voltage is measured as lower than 4mV at $0.01\mu$A current source current, lower than 400mV at $1\mu$A and higher than 400mV at 1 mA, $1\mu$A is selected as the measurement current. The value of the measured resistance can be worked out, which is between 400 K$\Omega$ and 40M$\Omega$.

c. When the voltage is measure near to zero at 0.01 pA current source current, less than 0.4mV at $1\mu$A and less than 400mV at 1 mA current source current, 1 mA is selected as the measurement current. The value of the measured resistance can be worked out, which is a value less than 400 $\Omega$. To increase the effective number digits of the readings, the voltmeter of function part A can be changed to 400mV range at this time. Under conditions that continuity measurement warning function is necessary; a step of judging whether it is lower than the warning threshold is added.

3. If the measured object is a diode, it can be separated from other cases in accordance with Table 1

Under diode back state, there generally will be high impedance. The said high impedance can be equal to open circuit or impedance less than 40M$\Omega$ that can be measured by a lower current source for the difference of backward leakage current of each diode. The following treatment is necessary at this time:

a. If the highest output voltage (e.g. 2V) of the current source is measured at 1 mA current source, the lower impedance measured at lower current shall be taken as the measurement result;

b. If the voltage measured is lower than the highest output voltage when the current source is 1 mA, showing that there is backward breakdown, the voltage measured at this time shall be taken as the measurement result, because it may be a Zener diode with a breakdown voltage lower than 2V, for example, a 1.2V Zener diode.

Under diode forward state, there will different break-over state under action of different current source. The high impedance, lower impedance, lowest impedance said in Table 1 is in relative term. Based on the forward feature of diode, there is lower impedance at higher current. At this time, voltage value measured at 1 mA current shall be displayed in the way that common multimeter measures diode.

During the above measurement, return to the original state and re-judge as soon as an abnormal voltage is measured.

Based on the above-mentioned invention, a digital multimeter that selects measurement function only with one button can also be realized. That is, just by adding a function selection button, the automatic function selection state will exit under the control of internal microprocessor when this button is pushed, and a measurement fixing on a certain measurement function state is available by adjusting internal electronic switch and auxiliary source based on different measurement functions. By pushing this function selection button once after another, the measurement function can be switched and selected. For example, the initial state at startup is automatic function selection state; it will enter resistance measurement function by pushing function selection button; AC voltage measurement function by another pushing; when pushing again, it will enter, in sequence, DC voltage measurement, frequency measurement, diode measurement, continuity measurement, capacitor measurement, inductance measurement, DC current measurement, AC current measurement and then back to automatic selection measurement state for functions including voltage, resistance, current and others. Attached Drawing 3 provides its principle block diagram.

Attached Drawing 4 demonstrates that, based on the above-mentioned invention, some additional functions commonly seen on common digital multimeter including data hold, display of maximum /minimum value, display of difference value as well as RS 232 communication function of connecting external PC can fully be added upon demands.

While particular embodiments of the invention have been shown and described, it will be obvious to those skilled in the art that changes and modifications may be made without departing from the invention in its broader aspects, and therefore, the aim in the appended claims is to cover all such changes and modifications as fall within the true spirit and scope of the invention.

**Claims**

**1.**  A digital multimeter for automatically selecting measurement functions comprising:

input ports of measured object;
an analog/digital conversion circuit;
a microprocessor;
a voltage divider network;
an electronic switch; and
a display; and
a high speed A/D

**characterized in that,**
said high speed A/D is connected to said input port of measured object by voltage divider network to get a fast measurement of voltage between input ports;
said high speed A/D circuit inputs data into said microprocessor for analysis and processing, said microprocessor controls said electronic switch to switch the voltage divider network and choose the measuring range for the high speed A/D;
said microprocessor controls the assistant programme control voltage and current source to be connected to a passive measured object of the input port and, in accordance with the result of voltage variation on the input port measured by high speed A/D, choose the measurement method and range for the passive measured object;
said microprocessor controls the display to show the measured result.

2. The digital multimeter for automatically selecting measurement functions of claim 1, **characterized in that,**
said microprocessor automatically judge whether it is a DC or an AC signal in accordance with the data output by the high speed A/D when detecting an external voltage, and works out its measurement result by analysis and processing.

3. The digital multimeter for automatically selecting measurement functions of claim 1, **characterized in that,**
when no external voltage is detected at said input port, a different assistant programme control voltage or current source is input to the input port by said microprocessor; the high speed A/D inputs the measured result into the microprocessor for analysis, which can judge what analog amount the measured object connected between the input ports is, and the microprocessor properly processes the result measured by the high speed A/D and works out its measurement result by choosing a properly auxiliary program-controlled source to act on the measured object.

4. The digital multimeter for automatically selecting measurement functions of claim 2 or 3, **characterized in that,**
when said assistant programme control voltage and current source is active measured object at the input port, the connection between said program-controlled voltage or current source controlled by the microprocessor and said input port is cut off; when said assistant programme control voltage and current source is passive measured object at the input port, the connection between the said program-controlled voltage or current source controlled by the microprocessor and said input port is connected.

5. The digital multimeter for automatically selecting measurement functions of claim 4, **characterized in that,**
said program-controlled voltage or current source controlled by said high speed A/D and microprocessor combines to select measurement of multiple analog amounts as well as measuring range.

6. The digital multimeter for automatically selecting measurement functions of claim 5, **characterized in that,**
when measuring said passive analog amount object, a micro test current is output first to keep the input port as a circuit with high input impendence.

7. The digital multimeter for automatically selecting measurement functions of claims 1, **characterized in that,**
a selection button is added to connect said microprocessor, and the automatic selection of measurement functions can be exited by pushing the button, and be switched to mode of button selection measurement function that switches to a measurement function by pushing the button once.

8. The digital multimeter for automatically selecting measurement functions of claims 1, **characterized in that,**
said microprocessor can store and display the waveform graph of single variation along with the time or graph of value variation along with the time by storing partial measured data.

**Fig. 1**

Fig. 2

**Fig. 3**

**Fig. 4**

# INTERNATIONAL SEARCH REPORT

International application No.

PCT/CN2006/003611

### A. CLASSIFICATION OF SUBJECT MATTER

G01R 15/12（2006.01）i

According to International Patent Classification (IPC) or to both national classification and IPC

### B. FIELDS SEARCHED

Minimum documentation searched (classification system followed by classification symbols)

IPC[8]：G01R 15

Documentation searched other than minimum documentation to the extent that such documents are included in the fields searched

Electronic data base consulted during the international search (name of data base and, where practicable, search terms used)

EPODOC，WPI，PAJ，CPRS，CNKI：  multimeter, analogue 1w digital, A/D, automat+

### C. DOCUMENTS CONSIDERED TO BE RELEVANT

| Category* | Citation of document, with indication, where appropriate, of the relevant passages | Relevant to claim No. |
|---|---|---|
| Y | GB2273365A（GOSSEN METRAWATT GMBH）15 Jun. 1994（15.06.1994），figure 1, page 2 line 14 to page 10 line 2 in the description,  claims 1-9 | 1—8 |
| Y | CN1052951A（SAMSUNG ELECTRONICS CO LTD）10 Jul. 1991（10.07.1991），figure 3, page 5 lines 18 to 25 | 1—8 |
| Y | CN2480850Y（FU, Xuetao）06 Mar. 2002（06.03.2002），page 1 lines 23 to 26 in the description | 1—8 |
| A | US5557197A（GOSSEN METRAWATT GMBH）17 Sep. 1996（17.09.1996），the whole document | 1—8 |
| A | CN2566275Y（ZHANGZHOU ORIENT ELCTRONICS）13 Aug. 2003 （13.08.2003），the whole document | 1—8 |

☐ Further documents are listed in the continuation of Box C.   ☒ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim (S) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&"document member of the same patent family |

| Date of the actual completion of the international search | Date of mailing of the international search report |
|---|---|
| 11 May 2007(11.05.2007) | 0 7 · JUN 2007 (0 7 · 0 6 · 2 0 0 7) |
| Name and mailing address of the ISA/CN<br>The State Intellectual Property Office, the P.R.China<br>6 Xitucheng Rd., Jimen Bridge, Haidian District, Beijing, China<br>100088<br>Facsimile No. 86-10-62019451 | Authorized officer<br>SHU, Chang<br><br>Telephone No. (86-10)-62085724 |

Form PCT/ISA/210 (second sheet) (April 2007)

**INTERNATIONAL SEARCH REPORT**
Information on patent family members

International application No.

PCT/CN2006/003611

| Patent Documents referred in the Report | Publication Date | Patent Family | Publication Date |
|---|---|---|---|
| GB2273365A | 15-06-1994 | DE4234789A | 21-04-1994 |
| | | FR2697092A | 22-04-1994 |
| | | GB2273365B | 29-01-1997 |
| CN1052951A | 10-07-1991 | DE4032714A | 11-07-1991 |
| | | JP3211471A | 17-09-1991 |
| | | KR920009910B | 06-11-1992 |
| CN2480850Y | 06-03-2002 | NONE | |
| US5557197A | 17-09-1996 | DE4331796A | 23-03-1995 |
| | | EP0649026A | 19-04-1995 |
| | | JP7151792A | 16-06-1995 |
| | | TW336997A | 21-07-1998 |
| CN2566275Y | 13-08-2003 | NONE | |

**EP 2 073 024 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 200310112175